(19) **Europäisches Patentamt**
**European Patent Office**
**Office européen des brevets**

(11) **EP 2 128 988 A1**

(12) **EUROPÄISCHE PATENTANMELDUNG**

(43) Veröffentlichungstag:
**02.12.2009 Patentblatt 2009/49**

(51) Int Cl.:
*H03M 1/08* (2006.01)   *H03H 7/24* (2006.01)

(21) Anmeldenummer: **09006907.1**

(22) Anmeldetag: **22.05.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **28.05.2008 DE 202008007207 U**

(71) Anmelder: **Moeller GmbH
53115 Bonn (DE)**

(72) Erfinder: **Culca, Horea-Stefan
53797 Lohmar (DE)**

(54) **Schaltungsanordnung zur Ansteuerung eines Eingangs eines Mikrocontrollers**

(57) Die Erfindung betrifft eine Schaltungsanordnung zur Ansteuerung eines Analogeingangs eines Mikrocontrollers, die als Spannungsteiler aufgebaut ist und aus einem ersten Verbindungsstrang zwischen Mikrocontrollereingang und Messspannung (UM) und einem zweiten Verbindungsstrang zwischen Mikrocontrollereingang und Masse besteht. Der erste Verbindungsstrang besteht erfindungsgemäß aus mindestens zwei in Reihe geschalteten Widerständen (R11, R12) und der zweite Verbindungsstrang besteht aus mindestens zwei parallel geschalteten Widerständen (R21, R22).

Fig. 1

**EP 2 128 988 A1**

**Beschreibung**

Die Erfindung betrifft eine Schaltungsanordnung zur Ansteuerung eines Analogeingangs eines Mikrocontrollers, die als Spannungsteiler aufgebaut ist und aus einem ersten Verbindungsstrang zwischen Mikrocontrollereingang und Messspannung und einem zweiten Verbindungsstrang zwischen Mikrocontrollereingang und Masse besteht.

Die Erfindung ist nicht auf Analogeingänge von Mikrocontroller beschränkt, sondern bezieht sich auf alle Bausteine, welche integrierte Anlog-Digital-Wandler mit einem Analogeingang aufweisen (ASIC, etc). Im Folgenden wird nur der Mikrocontroller genannt, was nicht als Einschränkung verstanden werden soll.

In einem sicherheitsrelevanten Gerät kann es notwendig sein, dass ein Mikrocontroller eine Spannung überwachen muss, welche höher ist als die maximale Eingangsspannung eines Analog-Digital-Wandlers, der heute intern in einem Mikrocontroller am Eingang vorgeschaltet ist. Diese maximale Eingangsspannung ist in der Regel die Versorgungsspannung des Mikrocontrollers und liegt bei ca. 3V bis 5V. Um eine höhere Spannung zu messen, muss diese höhere Spannung, zum Beispiel über einen Spannungsteiler, auf einen niedrigeren Wert reduziert werden. Eine Überspannung am Eingang des Analog-Digital-Wandlers kann zu einer Zerstörung des Analog-Digital-Wandlers führen. Problematischer ist jedoch, dass eine Überspannung zusätzlich die Integrität des Mikrocontrollers beeinflussen kann, der dann die Sicherheitsfunktionen nicht mehr zuverlässig ausführen kann.

Die Verwendung eines einfachen Spannungsteilers ist jedoch problematisch, da ein Kurzschluss im Widerstand des Spannungsteilers gegen die zu messende Spannung oder eine Unterbrechung im Widerstand gegen die Masse des Spannungsteilers dazu führen kann, dass eine zu hohe Spannung am Eingang des Analog-Digital-Wandlers anliegt.

Eine Lösung im Stand der Technik sieht vor, dass ein Operationsverstärker mit ausreichend hoher Spannungsfestigkeit am Eingang vor den Analog-Digital-Wandler geschaltet wird und somit eine Trennung des Analog-Digital-Wandler-Eingangs von der hohen Spannung bewirkt. Nachteilig sind der hohe Platzbedarf und die hohen Kosten bei der Verwendung eines Operationsverstärkers.

Es ist somit Aufgabe der Erfindung, eine Ansteuerschaltung für den Analogeingang eines Mikrocontrollers zu entwickeln, welche kostengünstig ist und den Eingang des Mikrocontrollers gegen Überspannungen schützt.

Erfindungsgemäß wird die Aufgabe durch eine Anordnung nach Anspruch 1 gelöst. Vorteilhafte Ausführungsformen der Vorrichtung ergeben sich aus den Unteransprüchen.

Die Erfindung betrifft eine Schaltungsanordnung zur Ansteuerung eines Analogeingangs eines Mikrocontrollers, die als Spannungsteiler aufgebaut ist und aus einem ersten Verbindungsstrang zwischen Mikrocontrollereingang und Messspannung und einem zweiten Verbindungsstrang zwischen Mikrocontrollereingang und Masse besteht. Der erste Verbindungsstrang besteht aus mindestens zwei in Reihe geschalteten Widerständen und der zweite Verbindungsstrang besteht aus mindestens zwei parallel geschalteten Widerständen.

Vorteilhafterweise weisen die in Reihe geschalteten Widerstände denselben Widerstandswert auf. Es ist ebenfalls vorteilhaft, wenn die parallel geschalteten Widerstände denselben Widerstandswert aufweisen.

Dabei hat es sich als besonders vorteilhaft erwiesen, dass der Quotient aus einem Widerstandswert im ersten Verbindungsstrang und einem Widerstandswert im zweiten Verbindungsstrang größer oder gleich der Hälfte des Quotienten aus der maximalen Messspannung und der Versorgungsspannung des Mikrocontrollers abzüglich des Wertes 0,5 ist.

Ein Vorteil der erfindungsgemäßen Schaltvorrichtung besteht darin, dass bei einem Ausfall eines Widerstandes die Spannung UE, welche am Ausgang des Spannungsteilers und somit am Analogeingang des Mikrocontrollers anliegt, nicht in einem Maße ansteigt, der die Integrität des Mikrocontrollers in Frage stellt oder zu einer Zerstörung des Mikrocontrollers führen würde. Entsteht eine Unterbrechung im ersten Verbindungsstrang, ist die Ausgangsspannung UE = 0V. Bei einem Kurzschluß eines der Widerstände im ersten Verbindungsstrang bleibt die Ausgangsspannung UE bei richtiger Dimensionierung der Widerstandswerte unterhalb eines für den Mikrocontroller kritischen Wertes. Liegt ein Kurzschluss im zweiten Verbindungsstrang vor, ist die Ausgangsspannung UE direkt mit der Masse verbunden. Bei einer Unterbrechung eines der parallel geschalteten Widerstände des zweiten Verbindungsstrangs bleibt die Ausgangsspannung UE bei richtiger Dimensionierung der Widerstandswerte unterhalb eines für den Mikrocontroller kritischen Wertes.

Es zeigt:

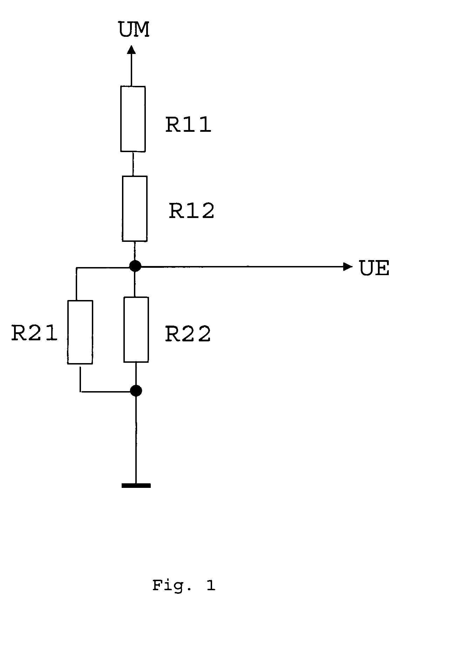

Fig. 1    eine Schaltungsskizze der erfindungsgemäßen Schaltungsvorrichtung.

Fig. 1 zeigt den erfindungsgemäßen Spannungsteiler mit einem ersten Verbindungsstrang, welcher sich zwischen dem Mikrocontrollereingang und der Messspannung UM befindet. Der erste Verbindungsstrang weist in diesem Ausführungsbeispiel zwei in Reihe geschaltete Widerstände R11, R12 auf.

Ein zweiter Verbindungsstrang zwischen dem Eingang des Mikrocontrollers und der Masse weist zwei parallel geschaltete Widerstände R21, R22 auf. Es können mehr als zwei Widerstände in den Verbindungssträngen in Reihe bzw. parallel geschaltet werden. Dadurch wird jedoch die Spannungsabweichung im Fehlerfall (Kurzschluss bzw. Unterbrechung eines Widerstandes) geringer, was zu einem geringeren Nutzmessbereich führt.

Die Ausgangsspannung des Spannungsteilers nach Fig. 1 ist für R1=R11=R12 und R2=R21=R22

$$UE = \frac{UM}{1+4\times\frac{R1}{R2}} = \frac{UM}{1+4\times q} \quad \text{für} \quad q = \frac{R1}{R2}$$

Ist ein Widerstand R1 kurzgeschlossen oder ein Widerstand R2 unterbrochen, ergibt sich für $q = \frac{R1}{R2}$ und R1=R11=R12 und R2=R21=R22 die Eingangsspannung UEf im Fehlerfall zu

$$UEf = \frac{UM}{1+2\times q}$$

Um die Funktion eines sicheren Spannungsteilers zu gewährleisten, müssen zwei Bedingungen erfüllt sein.
Zum einen darf die maximale Ausgangsspannung UE im Fehlerfall die Versorgungsspannung Vcc des Mikrokontrollers nicht überschreiten. Dann ist

$$Vcc \geq \frac{UM\max}{1+2\times q} \quad \text{(für} \quad q = \frac{R1}{R2} \quad \text{und R1=R11=R12 und R2=R21=R22)}$$

und R1=R11=R12 und R2=R21=R22)
Daraus folgt, dass

$$q \geq \frac{1}{2}\times\left(\frac{UM\max}{Vcc}-1\right)$$

Somit muss bei Verwendung der gleichen Widerstände R1=R11=R12 im ersten Strang und der gleichen Widerstände R2=R21=R22 im zweiten Strang des Spannungsteilers der Quotient aus dem Widerstandswert R1 aus dem ersten Verbindungsstrang und dem Widerstandswert R2 aus dem zweiten Verbindungsstrang größer oder gleich der Hälfte des Quotienten aus der maximalen Messspannung UM und der Versorgungsspannung des Mikrocontrollers Vcc abzüglich des Wertes 0,5 sein.
Die zweite Bedingung für den sicheren Spannungsteiler ist, dass die maximale Ausgangsspannung UEmax im Normalfall kleiner als die minimale Fehlerausgangsspannung UEfmin sein muss, damit ein fehlerhafter Widerstand sicher erkannt werden kann:

$$UE\max < UEf\min \quad \text{bzw.} \quad \frac{UM\max}{1+4\times q} < \frac{UM\min}{1+2\times q} \quad \text{oder} \quad \frac{UM\max}{UM\min} < \frac{1+4\times q}{1+2\times q}$$

Da q als Verhältnis der Widerstände R1 und R2 im Fehlerfall zwischen null (R1<<R2) und unendlich (R1>>R2) schwanken kann, ergibt sich nach Bildung der Grenzwerte gegen null und unendlich von $\frac{1+4\times q}{1+2\times q}$ ein Bereich zwischen

$$\frac{UM\max}{UM\min} > 1 \text{ und } \frac{UM\max}{UM\min} < 2,$$ in welchem der Quotient von UMmax und UMmin schwanken darf.

Daraus ergibt sich ein Spannungsbereich UMmax, der kleiner sein muss, als das doppelte der Mindestspannung UMmin. Es ergibt sich daraus die zweite Bedingung, welche der sichere Spannungsteiler erfüllen muss zu:

$$q > \frac{1}{2} \times \frac{\dfrac{UM\max}{UM\min} - 1}{2 - \dfrac{UM\max}{UM\min}}$$

Aufgrund der Änderung der Ausgangsspannung UE in den Fehlerfälle Kurzschluss und Unterbrechung ist es nun möglich, einen Fehlerfall zu detektieren und zu melden. Im Fehlerfall werden dann die Ausgänge des sicherheitsrelevanten Gerätes, in welchem sich der Mikrocontroller befindet, augeschaletet und das sicherheitsrelevante Gerät in einen sicheren Zustand versetzt.

**Patentansprüche**

1. Schaltungsanordnung zur Ansteuerung eines Analogeingangs eines Mikrocontrollers, die als Spannungsteiler aufgebaut ist und aus einem ersten Verbindungsstrang zwischen Mikrocontrollereingang und Messspannung (UM) und einem zweiten Verbindungsstrang zwischen Mikrocontrollereingang und Masse besteht,
**dadurch gekennzeichnet,**
**dass** der erste Verbindungsstrang aus mindestens zwei in Reihe geschalteten Widerständen (R11, R12) besteht und der zweite Verbindungsstrang aus mindestens zwei parallel geschalteten Widerständen (R21, R22) besteht.

2. Schaltungsanordnung nach Anspruch 1
**dadurch gekennzeichnet,**
**dass** die in Reihe geschalteten Widerstände (R11, R12) denselben Widerstandswert (R1) aufweisen.

3. Schaltungsanordnung nach einem der vorhergehenden Ansprüche,
**dadurch gekennzeichnet,**
**dass** die parallel geschalteten Widerstände (R21, R22) denselben Widerstandswert (R2) aufweisen.

4. Schaltungsanordnung nach Anspruch 2 und Anspruch 3,
**dadurch gekennzeichnet,**
**dass** der Quotient aus einem Widerstandswert (R1) im ersten Verbindungsstrang und einem Widerstandswert (R2) im zweiten Verbindungsstrang größer oder gleich der Hälfte des Quotienten aus der maximalen Messspannung (UMmax) und der Versorgungsspannung (Vcc) abzüglich des Wertes 0,5 ist.

Fig. 1

Europäisches
Patentamt

European
Patent Office

Office européen
des brevets

**EUROPÄISCHER RECHERCHENBERICHT**

Nummer der Anmeldung

EP 09 00 6907

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 03/025592 A1 (INFINEON TECHNOLOGIES AG [DE]; DREXEL WERNER [AT]; SAMEC CHRISTIAN [AT]) 27. März 2003 (2003-03-27) | 1 | INV. H03M1/08 H03H7/24 |
| Y | * Abbildungen 1,2 * | 2-4 | |
| X | EP 1 589 646 A2 (THOMSON LICENSING [FR]) 26. Oktober 2005 (2005-10-26) | 1-2 | |
| Y | * Abbildungen 2a,3 * | 3-4 | |
| Y | DE 41 09 586 A1 (SIEMENS AG [DE]) 24. September 1992 (1992-09-24) * Abbildung 2 * | 1-4 | |
| A | US 6 259 300 B1 (YASUDA TAKEO [JP]; HATANI NAOHISA [JP]) 10. Juli 2001 (2001-07-10) * Abbildung 2 * | 1-4 | |
| Y | JP 57 208727 A (MITSUBISHI ELECTRIC CORP) 21. Dezember 1982 (1982-12-21) * das ganze Dokument * | 1-4 | |
| A | JP 57 076918 A (FUJISOKU ELECTRIC) 14. Mai 1982 (1982-05-14) * das ganze Dokument * | 1-4 | RECHERCHIERTE SACHGEBIETE (IPC) H03M H03H |
| X | GB 2 278 735 A (MOTOROLA BV [NL]) 7. Dezember 1994 (1994-12-07) * Zeile 26 - Seite 5, Zeile 37; Abbildung 3 * | 1 | |

Der vorliegende Recherchenbericht wurde für alle Patentansprüche erstellt

| Recherchenort | Abschlußdatum der Recherche | Prüfer |
|---|---|---|
| München | 15. September 2009 | Müller, Uta |

**EP 2 128 988 A1**

**ANHANG ZUM EUROPÄISCHEN RECHERCHENBERICHT
ÜBER DIE EUROPÄISCHE PATENTANMELDUNG NR.**                    EP 09 00 6907

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-09-2009

| Im Recherchenbericht angeführtes Patentdokument | | Datum der Veröffentlichung | Mitglied(er) der Patentfamilie | | Datum der Veröffentlichung |
|---|---|---|---|---|---|
| WO 03025592 | A1 | 27-03-2003 | DE | 10142011 A1 | 03-04-2003 |
| EP 1589646 | A2 | 26-10-2005 | KEINE | | |
| DE 4109586 | A1 | 24-09-1992 | KEINE | | |
| US 6259300 | B1 | 10-07-2001 | JP | 3292167 B2 | 17-06-2002 |
| | | | JP | 2000244316 A | 08-09-2000 |
| JP 57208727 | A | 21-12-1982 | KEINE | | |
| JP 57076918 | A | 14-05-1982 | KEINE | | |
| GB 2278735 | A | 07-12-1994 | KEINE | | |

EPO FORM P0461

Für nähere Einzelheiten zu diesem Anhang : siehe Amtsblatt des Europäischen Patentamts, Nr.12/82